# FASCICULE DE BREVET EUROPEEN

(11) **EP 3 012 880 B1**
(45) Date de publication et mention de la délivrance du brevet: **29.11.2017**
(21) Numéro de dépôt: 15189988.7
(22) Date de dépôt: 15.10.2015
(51) Int. Cl.: H01L 43/12, H01L 43/08, G11C 11/16, H01F 10/32

(54) **DISPOSITIF MÉMOIRE NON VOLATILE HYBRIDE ET PROCÉDÉ DE FABRICATION D'UN TEL DISPOSITIF**
NICHT-FLÜCHTIGE HYBRID-SPEICHERVORRICHTUNG, UND HERSTELLUNGSVERFAHREN EINER SOLCHEN VORRICHTUNG
HYBRID NON-VOLATILE MEMORY DEVICE AND METHOD FOR MANUFACTURING SUCH A DEVICE

(30) Priorité: 20.10.2014 FR 1460078
(43) Date de publication de la demande: 27.04.2016
(73) Titulaire: COMMISSARIAT À L'ÉNERGIE ATOMIQUE ET AUX ÉNERGIES ALTERNATIVES, 75015 Paris (FR)
(72) Inventeur: PERNIOLA, Luca, 38360 Noyarey (FR); DIENY, Bernard, 38250 Lans en Vercors (FR)
(74) Mandataire: Cabinet Camus Lebkiri

(56) Documents cités:
- FR-A1- 2 972 286
- US-A1- 2003 209 746
- US-A1- 2007 103 964

## Description

### DOMAINE TECHNIQUE

La présente invention est relative au domaine des mémoires non-volatiles à éléments résistifs, et plus particulièrement à un dispositif mémoire incorporant des éléments mémoire de type OxRAM (« Oxide Resistive Random Access Memory »).

### ETAT DE LA TECHNIQUE

Plusieurs technologies de mémoires non-volatiles sont en cours de développement avec des degrés de maturité divers. On peut citer notamment les mémoires à changement de phase PCRAM (« Phase Change RAM »), les mémoires résistives à pont conducteur CBRAM (« Conductive Bridge RAM ») ou bien à base d'oxyde OxRAM, les mémoires ferroélectriques FeRAM et les mémoires magnétiques MRAM. Hormis les mémoires FeRAM qui fonctionnent selon le principe de l'orientation d'un moment dipolaire électrique dans un matériau ferroélectrique, toutes les autres mémoires utilisent des matériaux de résistance électrique variable. Chaque bit d'information est stocké dans un point mémoire comprenant un élément de résistance variable. Le bit d'information est codé par la valeur de résistance de cet élément de stockage. Typiquement, le niveau logique '0' correspond à une forte valeur de résistance et le niveau logique '1' correspond à une faible valeur de résistance.

Le mécanisme à l'origine de la variation de résistance dépend de la technologie utilisée. Dans les PCRAM par exemple, il s'agit de matériaux semi-conducteurs chalcogénures que l'on peut faire transiter d'un état amorphe à un état cristallin (ou inversement), par des impulsions de courant d'amplitude et durée appropriées. Dans les MRAM, l'élément de stockage est une jonction tunnel magnétique présentant un effet de magnétorésistance tunnel. Dans les CBRAM, on forme ou on détruit des filaments conducteurs en faisant diffuser des ions métalliques (par exemple Ag⁺) dans une matrice semi-conductrice (par exemple Ge). Enfin, les OxRAM ont un comportement similaire à celui des CBRAM dans le sens où un filament conducteur se forme dans un oxyde. Ce filament est formé par accumulation de lacunes d'oxygène (au moins pour la famille des oxydes à base de métaux de transition), plutôt que par accumulation d'ions métalliques. Toutes ces formes de mémoire impliquent le passage d'un courant à travers l'élément de stockage, lequel présente une résistance électrique variant entre une valeur minimale et une valeur maximale.

Chacune de ces technologies de mémoire non-volatile présentent des avantages et des inconvénients. Par exemple, les MRAM sont rapides et supportent un nombre de cycles de lecture/écriture quasiment illimité mais ont une densité d'intégration moindre que les mémoires résistives de type OxRAM et CBRAM. Les OxRAM et CBRAM bénéficient d'une faible consommation et d'une forte densité d'intégration, mais la variabilité des performances entre les points mémoire est importante. Ces deux types de mémoire présentent en outre l'avantage de pouvoir être intégrés au-dessus d'un circuit logique, par exemple un microprocesseur (intégration « BEOL »).

Pour profiter pleinement de ces différents avantages, il est d'usage de combiner plusieurs technologies de mémoire. Autour du microprocesseur, on peut notamment prévoir de la MRAM (vitesse et endurance élevées) pour remplacer la mémoire SRAM (« Static Random Access Memory ») actuelle des niveaux « cache » (niveaux L1 à L3), et de la PCRAM comme mémoire principale au lieu de la mémoire DRAM (« Dynamic Random Access Memory »). Plus loin du microprocesseur, les mémoires OxRAM et CBRAM (forte densité d'intégration et faible consommation) remplacent avantageusement la mémoire « Flash » en tant que mémoires de stockage de masse.

A l'heure actuelle, ces différentes mémoires non-volatiles sont formées par autant de composants électroniques connectés sur un même circuit imprimé (par exemple une carte-mère). Pourtant, l'intégration de deux (ou plus) types de mémoire au sein d'un même composant, c'est-à-dire sur un même substrat semi-conducteur, permettrait un traitement plus efficace de l'information par le microprocesseur. En effet, les flux d'information seraient augmentés, du fait du rapprochement entre les mémoires. La co-intégration de plusieurs types de mémoire faciliterait également le remplacement des mémoires volatiles (SRAM, DRAM) par les mémoires non-volatiles et améliorerait la distribution des mémoires autour du microprocesseur. Il existe donc aujourd'hui un besoin de prévoir un dispositif mémoire combinant plusieurs technologies émergentes de mémoire non volatile sur un même substrat afin de bénéficier simultanément des avantages liés à chacune de ces technologies.

Parmi les mémoires OxRAM, on peut distinguer celles disposant d'un dispositif de sélection (typiquement un transistor), qui permet lors de la lecture d'un point mémoire de limiter les courants de fuite vers les points mémoire adjacents, et celles dépourvues d'un tel dispositif de sélection. Ces dernières sont qualifiées de « selector-less » selon la terminologie anglo-saxonne. L'article [« Selector-less ReRAM with an excellent non-linearity and reliability by the band-gap engineered multi-layer titanium oxide and triangular shaped AC puise » ; Lee S. et al., Electron Devices Meeting (IEDM), pp.10.6.1-10.6.4, 2013] décrit un exemple de mémoire résistive OxRAM sans sélecteur.

Les OxRAM sans sélecteur ont une structure plus compacte (de par l'absence du transistor de sélection). Le problème de courants de fuite y est résolu en connectant une diode en série avec la couche active formée par un oxyde métallique (ex. HfO₂, Ta₂O₅). Cette diode remplit la fonction de sélecteur, car la mémoire présente alors une caractéristique courant-tension non linéaire dotée d'une tension de seuil.

La demande de brevet US2014/0158967 donne un autre exemple de mémoire résistive OxRAM sans sélecteur (appelée aussi « auto-sélective ») formée en déposant une première couche de métal (par exemple en titane) sur un substrat, en oxydant la première couche de métal afin de former une première couche d'oxyde (TiO₂), puis en déposant une deuxième couche d'oxyde (ex. Ta₂O₅) et une deuxième couche de métal (ex. Ta). Les première et seconde couches de métal forment respectivement les électrodes inférieure et supérieure. La première couche d'oxyde forme une diode Schottky avec l'électrode inférieure et la deuxième couche d'oxyde en contact (ohmique) avec l'électrode supérieure constitue la couche active, siège de la formation des filaments conducteurs.

Pour délimiter les différents points mémoire, cet empilement de couches est généralement gravé, typiquement par gravure plasma réactive. Or, pour des dimensions de points mémoire inférieures à 30 nm, cette gravure peut provoquer un endommagement du matériau actif, soit l'oxyde bistable en résistance (Ta₂O₅ dans l'exemple ci-dessus). En outre, la gravure plasma réactive peut être à l'origine de nombreux défauts structurels et/ou chimiques aux bords des points mémoire. Il est fait aussi référence aux documents FR2972286 et US2003209746.

### RESUME DE L'INVENTION

L'invention vise à intégrer dans le même dispositif mémoire plusieurs types d'éléments mémoire (ou éléments de stockage) de résistance électrique variable sur un même substrat, dont des éléments de type OxRAM sans sélecteur, tout en limitant l'endommagement et les défauts des éléments mémoire.

On tend à remplir cet objectif en prévoyant un procédé de fabrication d'un dispositif mémoire non-volatile hybride comprenant les étapes suivantes :
- former un premier groupe de plots électriquement conducteurs espacés les uns des autres dans une première zone d'un substrat ;
- déposer une première couche électriquement conductrice sur une seconde zone du substrat ;
- graver la première couche conductrice, de sorte à obtenir un second groupe de plots électriquement conducteurs espacés les uns des autres dans la seconde zone, les conditions de gravure étant choisies de sorte que les plots conducteurs de la seconde zone aient une section à leur base plus petite qu'à leur sommet ;
- protéger la face supérieure des plots conducteurs de la seconde zone ;
- soumettre le substrat à un traitement d'oxydation, d'où il résulte une couche en matériau isolant recouvrant la face supérieure des plots conducteurs de la première zone et les flancs des plots conducteurs de la seconde zone ;
- déposer une couche d'oxyde aux sommets des plots conducteurs de la première zone, d'où il résulte des éléments mémoire d'un premier type supportés par les plots conducteurs de la première zone ; et
- former par dépôt physique en phase vapeur des éléments mémoire d'un second type aux sommets des plots conducteurs de la seconde zone, de sorte que chaque élément mémoire du second type est supporté par l'un des plots conducteurs de la seconde zone.

La première zone du substrat est dédiée aux éléments mémoire de type OxRAM sans sélecteurs ou auto-sélecteurs. La couche d'oxyde déposée aux sommets des plots conducteurs de la première zone forme la couche active de ces éléments mémoire. Elle peut être continue d'un élément mémoire à l'autre, car elle est isolante électriquement. Elle n'a donc pas besoin d'être gravée pour éviter un court-circuit entre les éléments mémoire. Les éléments mémoire OxRAM sont différenciés par les plots conducteurs sous-jacents, qui forment des électrodes inférieures.

La seconde zone du substrat est consacrée à la formation d'éléments d'un autre type que ceux de la première zone, par exemple MRAM ou PCRAM. Dans la seconde zone, les plots conducteurs présentent des flancs surplombants (ou « rentrants »), de sorte que lorsqu'on dépose le matériau résistif des éléments mémoire MRAM ou PCRAM, la couche de ce matériau résistif se discrétise aux sommets des plots et entre les plots. En d'autres termes, les plots ou piliers évasés de la seconde zone permettent de structurer naturellement les éléments mémoire MRAM ou PCRAM, sans qu'on ait besoin de graver a posteriori le matériau résistif. Par « matériau résistif », on entend le ou les matériaux qui constituent l'élément mémoire de résistance variable. Il peut s'agir d'un matériau conducteur jouant le rôle d'électrode (par exemple la couche de référence magnétique dans une mémoire MRAM) ou du matériau actif, c'est-à-dire celui qui remplit la fonction de stockage (par exemple la couche à changement de phase dans une mémoire PCRAM).

Ainsi, une gravure du matériau résistif est évitée, aussi bien dans la première zone pour la formation des éléments mémoire OxRAM que dans la seconde zone pour la formation des éléments mémoire MRAM ou PCRAM. Puisqu'on s'affranchit de l'étape de gravure du matériau résistif par gravure plasma réactive, les éléments mémoire contiennent moins de défauts structurels et/ou chimiques sur les bords. Par conséquent, dans chacune des zones du substrat, le dispositif mémoire hybride selon l'invention présente moins de variabilité d'un point mémoire à l'autre en termes de performances. En outre, les éléments mémoire MRAM ou PCRAM ne risquent pas d'être corrodés comme c'est généralement le cas avec une gravure par plasma réactif.

Les plots conducteurs sont isolés électriquement les uns des autres dans la première zone, car la couche d'oxyde qui les relie, généralement un oxyde de métal de transition (ex. HfO₂, Ta₂O₅), est électriquement isolante. Dans la seconde zone, les plots conducteurs sont également isolés les uns des autres, malgré la présence de matériau résistif conducteur (par exemple magnétique ou à changement de phase) au fond des tranchées séparant les plots évasés, grâce au fait que ce matériau ne recouvre pas les flancs à la base des plots. En effet, le dépôt du matériau résistif des éléments MRAM ou PCRAM s'effectuant selon un procédé sensiblement directif, par dépôt physique en phase vapeur (PVD) tel que la pulvérisation cathodique ou l'évaporation, la partie supérieure en surplomb de chaque plot empêche par effet d'ombrage le dépôt du matériau au pied des flancs.

En outre, l'isolation électrique entre les plots conducteurs évasés de la seconde zone est renforcée par la présence de la couche de matériau isolant sur leurs flancs. Cette couche isolante est formée simultanément sur la face supérieure des plots de la première zone, au soumettant l'ensemble des plots du substrat au traitement d'oxydation. Aux sommets des plots conducteurs de la première zone, la couche isolante remplit la fonction de redresseur de courant, selon le principe d'une diode. Un comportement semblable à celui des mémoires OxRAM avec dispositif de sélection peut alors être obtenu, car la caractéristique courant-tension de ces points mémoire est non linéaire et dispose d'une tension de seuil. En fonction des matériaux formant les plots conducteurs des première et seconde zones, le matériau qui constitue la couche isolante sur la face supérieure des plots de la première zone peut être différent de celui qui constitue la couche isolante sur les flancs des plots de la seconde zone.

Comme la face supérieure des plots de la seconde zone est protégée lors du traitement d'oxydation, la couche isolante ne s'y forme pas. La continuité électrique entre chaque plot conducteur et l'élément mémoire correspondant est ainsi assurée. Les plots conducteurs de la première zone n'ont pas nécessairement des flancs surplombants, comme ceux de la seconde zone. En effet, comme il est inutile de « découper » la couche d'oxyde métallique, ils peuvent avoir des flancs verticaux ou inclinés, avec une section à leur base plus grande qu'à leur sommet (flancs « sortants »).

Dans un mode de mise en oeuvre préférentiel du procédé de fabrication, les plots de la première zone du substrat sont formés de piliers identiques à ceux de la seconde zone. Ils sont formés en même temps que les plots conducteurs de la seconde zone, en gravant la première couche conductrice préalablement déposée sur les première et seconde zones. Les conditions de gravure sont donc choisies de sorte que les plots conducteurs de la première zone aient aussi une section à leur base plus petite qu'à leur sommet.

Avantageusement, le procédé comporte en outre une étape de dépôt d'une seconde couche conductrice, par exemple en titane, sur la première couche conductrice dans la première zone, les première et seconde couches conductrices étant gravées simultanément pour former les plots conducteurs de la première zone.

Lorsque les éléments mémoire du second type (ex. MRAM ou PCRAM) sont formés simultanément par dépôt physique en phase vapeur aux sommets des plots conducteurs de la première zone et aux sommets des plots conducteurs de la seconde zone, le procédé comprend en outre, avant l'étape de dépôt de la couche d'oxyde, les étapes suivantes :
- recouvrir les plots conducteurs des première et seconde zones d'un matériau diélectrique ;
- graver le matériau diélectrique dans la première zone jusqu'à découvrir les éléments mémoire de la première zone ; et
- éliminer les éléments mémoire de la première zone.

La couche d'oxyde est avantageusement déposée sur les première et seconde zones par PECVD ou ALD.

Dans une variante de mise en oeuvre, les plots conducteurs de la première zone sont formés avant le dépôt de la première couche conductrice sur la seconde zone, leur forme pouvant être différente de celle des plots de la seconde zone.

Le procédé selon l'invention peut également présenter une ou plusieurs des caractéristiques ci-dessous, considérées individuellement ou selon toutes les combinaisons techniquement possibles :
- la face supérieure des plots conducteurs de la seconde zone est protégée en formant dans la seconde zone une couche de protection sur la première couche conductrice, avant l'étape de gravure de la première couche conductrice ;
- la couche de protection, par exemple en ruthénium, occupe toute la seconde zone et est gravée en même temps que la première couche conductrice pour former les plots conducteurs de la seconde zone ;
- la couche de protection est constituée par un masque de gravure servant à graver la première couche conductrice, ce masque étant préférentiellement retiré après le traitement d'oxydation ;
- la première couche conductrice est gravée par gravure plasma réactive.

Un autre aspect de l'invention concerne un dispositif mémoire non-volatile hybride comprenant :
- un substrat comportant des première et seconde zones ;
- une pluralité de plots électriquement conducteurs disposés sur le substrat et répartis entre les première et seconde zones, les plots de la seconde zone ayant une section à leur base plus faible qu'à leur sommet ;
- une couche électriquement isolante recouvrant les flancs des plots conducteurs de la seconde zone et au moins la face supérieure des plots conducteurs de la première zone ;
- une première couche de stockage en oxyde recouvrant les plots conducteurs de la première zone, d'où il résulte une pluralité d'éléments mémoire d'un premier type dans la première zone ; et
- une pluralité d'éléments mémoire d'un second type disposés aux sommets des plots conducteurs de la seconde zone, de sorte que chaque élément mémoire est supporté par l'un des plots conducteurs de la seconde zone, les éléments mémoire du second type comprenant une seconde couche de stockage électriquement conductrice.

### BREVES DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1 représente schématiquement un substrat sur lequel peut être fabriqué un dispositif mémoire hybride selon l'invention ;
- les figures 2A à 2J représentent des étapes F1 à F10 d'un procédé de fabrication d'un dispositif mémoire hybride, d'après un mode de mise en oeuvre préférentiel de l'invention ; et
- les figures 3A à 3C représentent des étapes F1' à F3' d'un procédé de fabrication de dispositif mémoire hybride, d'après une variante de mise en oeuvre de l'invention.

Pour plus de clarté, les éléments identiques ou similaires sont repérés par des signes de références identiques sur l'ensemble des figures.

### DESCRIPTION DETAILLEE D'AU MOINS UN MODE DE REALISATION

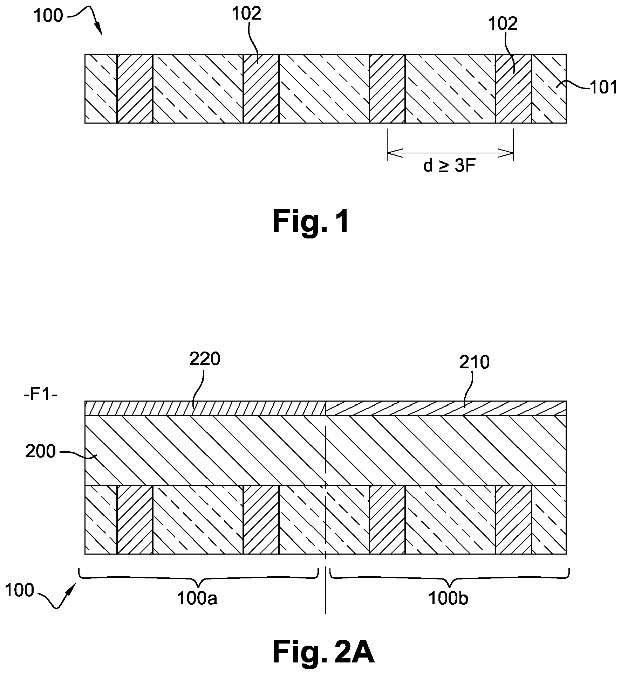

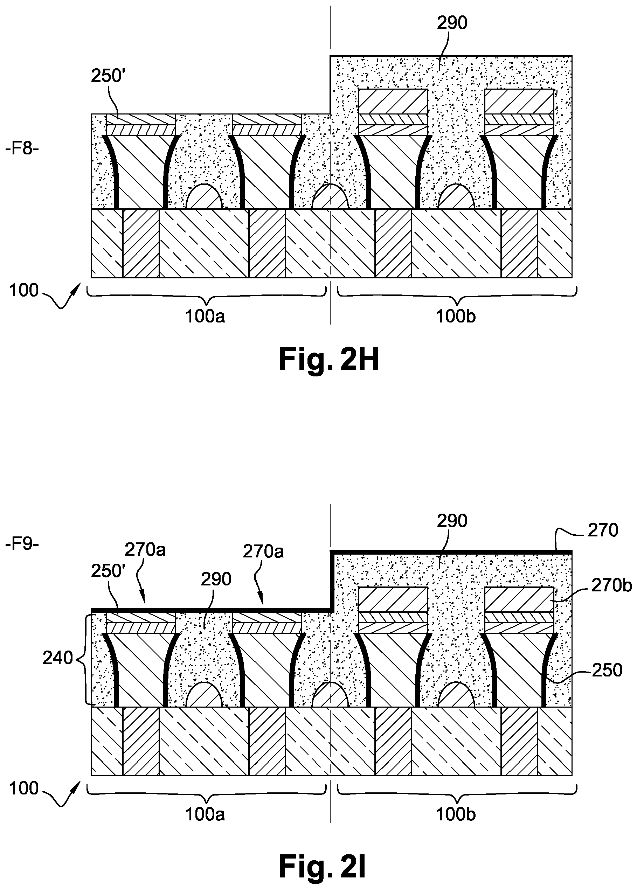

Un mode de mise en oeuvre préférentiel d'un procédé de fabrication de dispositif mémoire hybride est décrit ci-dessous en référence aux figures 1, 2A à 2J. La figure 1 montre un substrat 100 qui sert de point de départ au procédé de fabrication, tandis que les figures 2A à 2J représentent des étapes F1 à F10 du procédé de fabrication.

Ce procédé vise à intégrer sur le substrat 100 un groupe de points mémoire de type OxRAM sans sélecteur et un groupe de points mémoire non volatile d'une autre technologie, par exemple MRAM ou PCRAM. Ces deux groupes de points mémoire sont, de préférence, organisés en matrices. Autrement dit, les points mémoire sont rangés en lignes et colonnes à la surface du substrat 100. Chaque point mémoire comprend un élément mémoire, ou élément de stockage, de résistance électrique variable.

Le substrat 100 comporte avantageusement un circuit CMOS capable d'adresser chaque point mémoire du dispositif mémoire hybride et lire la donnée enregistrée dans l'élément mémoire, soit la valeur de résistance électrique de cet élément. Ce circuit comporte par exemple des transistors reliés électriquement aux éléments mémoire par un ou plusieurs niveaux d'interconnexion. Sur la figure 1, on a représenté en coupe transversale uniquement le dernier niveau d'interconnexion avant les points mémoire. Il est formé d'une couche en matériau diélectrique 101 (par exemple en SiO₂ ou Al₂O₃) traversée par des motifs d'interconnexion 102, tels que des via conducteurs ou des lignes conductrices, typiquement en métal (cuivre, aluminium...). Ces motifs d'interconnexion 102 permettent de relier électriquement les éléments mémoire au circuit CMOS.

Pour les applications mémoire non volatile, on cherche généralement à intégrer les éléments de stockage aussi haut que possible dans l'empilement, afin d'optimiser le processus de fabrication. De préférence, les piliers conducteurs du dispositif mémoire hybride sont formés au-dessus de l'un des derniers niveaux de métal.

Les via conducteurs (ou lignes conductrices) 102 sont (dans les technologies actuelles) typiquement éloignés d'une distance d supérieure ou égale à 3F, où F désigne la résolution du dispositif mémoire, c'est-à-dire la dimension minimale atteignable par lithographie (« half-pitch » en anglais). Cette valeur de 3F correspond par exemple en technologie CMOS à la distance séparant deux via émergents consécutifs de transistors MOSFET.

Bien entendu, comme n'importe quel niveau de métal du substrat, le niveau d'interconnexion de la figure 1 peut comporter d'autres motifs (type via ou ligne) que ceux destinés à relier électriquement les éléments mémoire (et référencés 102). Par exemple, ces autres motifs peuvent relier un niveau inférieur à un niveau supérieur à celui des éléments mémoire ou deux transistors MOS situés plus bas dans le substrat. Dans le cas de lignes, ils ne sont d'ailleurs pas nécessairement traversants. Les étapes F1 à F10 décrites ci-dessous en relation avec les figures 2A à 2J permettent de réaliser, sur ce substrat de départ 100, des nanostructures verticales connectées en série avec les via conducteurs 102 et isolées les unes des autres. Parmi ces nanostructures verticales, on distinguera des points mémoire de type OxRAM sans sélecteur et des points mémoire de type MRAM ou PCRAM. Ainsi, une première zone 100a du substrat 100 est dédiée à la formation des points mémoire de type OxRAM sans sélecteur et une deuxième zone 100b est destinée à la formation des points mémoire de type MRAM ou PCRAM (Fig.2A).

L'étape F1 de la figure 2A consiste à déposer sur le substrat 100 une première couche électriquement conductrice 200, par exemple en tantale. Cette couche 200 est destinée à former des plots conducteurs sur lesquels seront formés les éléments mémoire. La résistivité électrique du matériau de la couche 200 est telle que, une fois gravée en forme de mesa, la résistance électrique de chaque plot est faible, typiquement inférieure à la résistance maximale de l'élément mémoire. On minimise ainsi l'effet de résistance série parasite qui diminue la variation relative de signal au moment de lire l'état de l'élément mémoire (état faiblement résistif LRS ou fortement résistif HRS, « Low Resistive State » ou « High Resistive State » en anglais). De préférence, la résistivité électrique de la couche 200 est inférieure à 2.10⁴ µΩ.cm.

Le matériau de la couche conductrice 200 peut être choisi parmi le tantale (Ta), le tungstène (W), l'aluminium (Al), le titane (Ti), le nitrure de titane (TiN) et le silicium polycristallin (poly-Si) fortement dopé (concentration en dopants par exemple supérieure à 5.10¹⁸ cm⁻³ pour un dopage au phosphore). Tous ces matériaux remplissent la condition de résistivité ci-dessus.

Dans ce mode de mise en oeuvre préférentiel, la couche conductrice 200 occupe les première et seconde zones 100a-100b du substrat 100. Dans la zone 100b, la couche conductrice 200 est avantageusement recouverte d'une couche de protection 210, de préférence en un matériau dont l'oxyde est conducteur, tel que le ruthénium ou le chrome. La couche de protection 210 peut être obtenue par photolithographie et gravure. Le ruthénium est alors déposé sur les zones 100a et 100b du substrat 100, recouvert d'un masque de gravure, puis restreint à la zone 100b en le gravant dans la zone 100a au travers du masque.

Dans la zone 100a, la première couche conductrice 200 est avantageusement recouverte d'une seconde couche conductrice 220. La couche 220 est formée d'un matériau montrant des propriétés de rectification une fois oxydé (car, d'après Lee. et al. cet oxyde a une bande interdite plus petite que le celle de l'oxyde bistable HfO₂) et d'épaisseur avantageusement comprise entre 2 nm et 30 nm, préférentiellement entre 5 nm et 10 nm. Le matériau de la couche 220 est donc un matériau dont l'oxyde est isolant électriquement, par exemple le titane. Comme la couche de protection 210 dans la zone 100b, la couche 220 peut être limitée à la zone 100a par gravure. Le matériau de la couche 220 est déposé sur la zone 100a et la zone 100b, cette dernière étant recouverte de la couche 210, puis gravé jusqu'à atteindre le ruthénium de la couche 210. Alternativement, le matériau de la couche 220 est éliminé dans la zone 100b par polissage mécano-chimique (« Chemical Mechanical Planarization », CMP), avec arrêt du polissage sur la couche de ruthénium 210.

Dans cet exemple, la formation de la couche en ruthénium 210 a lieu avant la formation de la couche conductrice 220. On peut bien sûr inverser l'ordre de ces étapes, en utilisant les mêmes techniques de structuration (photolithographie et gravure de la couche conductrice 220, puis CMP ou gravure de la couche de ruthénium 210 avec arrêt sur la couche 220).

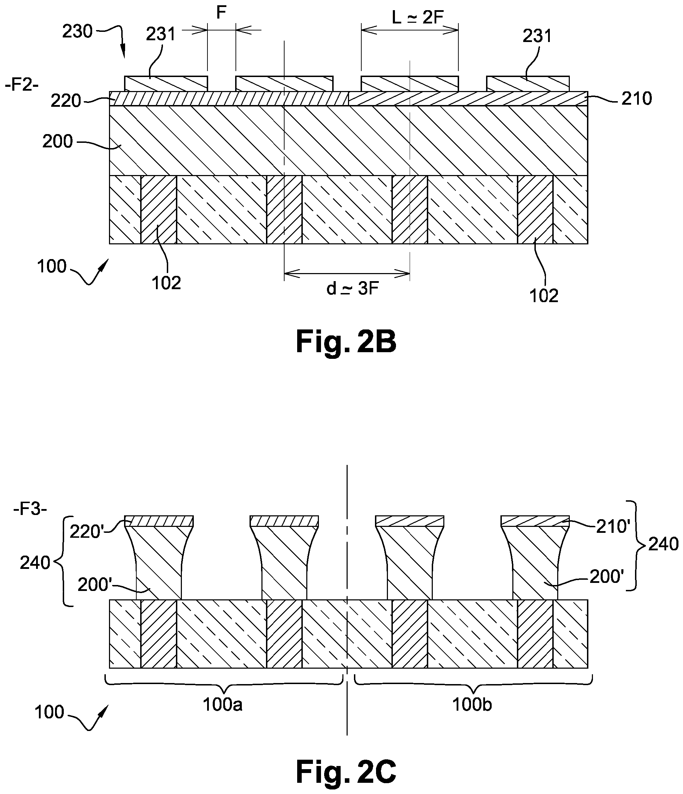

A l'étape F2 de la figure 2B, un masque de gravure 230 est formé sur les couches 210 et 220. De façon classique, le masque de gravure 230 peut être constitué d'une résine photosensible, structurée par photolithographie, ou d'un matériau plus résistant à la gravure que la résine photosensible - on parle dans ce cas de « masque dur ». Le masque dur est, par exemple, en oxyde de silicium (SiO₂), en nitrure de silicium (Si₃N₄), en oxynitrure de silicium (SiON) ou en carbone amorphe.

Les parties pleines du masque 230 constituent des motifs 231 situés à l'aplomb des via conducteurs 102 (ou lignes conductrices) du substrat 100 et ont la forme des éléments mémoire que l'on cherche à réaliser. Avantageusement, chaque motif 231 est centré par rapport au via conducteur 102 sous-jacent et présente des dimensions supérieures à celles du via (de sorte que le plot formé ultérieurement le recouvre entièrement). Par exemple, les motifs 231 peuvent avoir une largeur L approchant 2F (Fig.2B). Ainsi, lorsque les via 102 sont périodiquement espacés d'une distance égale à 3F, la distance bord à bord des motifs 231 adjacents est de l'ordre de F. La forme des motifs 231 est, de préférence, ronde pour des raisons d'homogénéité des propriétés électriques sur toute la périphérie des plots et pour faciliter la réalisation du dispositif hybride aux noeuds technologiques les plus avancés (sub-20nm). Néanmoins, d'autres formes peuvent être envisagées, notamment carrée, elliptique et rectangulaire.

En F3 (Fig.2C), les couches conductrices 200, 210 et la couche de protection en ruthénium 220 de la figure 2B sont gravées au travers du masque 230. Les conditions de gravure sont, dans ce mode de mise en oeuvre préférentiel, déterminées de sorte à obtenir simultanément dans les zones 100a et 100b des plots ou piliers conducteurs 240 aux flancs surplombants, par exemple selon un profil à encoche ou en arc de cercle. La technique de gravure utilisée lors de cette étape F3 est, de préférence, une gravure plasma réactive. En effet, celle-ci permet (dans le cas des métaux des couches 200, 210 et 220) d'obtenir des résidus de gravure volatils qui pourront être éliminés facilement, par pompage hors du réacteur de gravure. Une gravure plasma fortement isotrope devrait être évitée pour empêcher une gravure sous les motifs 231 du masque 230, ce qui réduirait les dimensions de la face supérieure des plots (et donc des éléments mémoire).

Les plots conducteurs 240 sont ici majoritairement formés du matériau de la première couche conductrice 200, par exemple le tantale, car la couche 200 possède une épaisseur bien supérieure à celle des couches 210 et 220. L'épaisseur de la couche 200 est, de préférence, comprise entre 4 nm et 400 nm. Les plots 240 sont chacun constitués d'un motif 200' obtenu en gravant la couche de tantale 200, coiffé d'un motif 210' (respectivement 220') provenant de la couche de protection 210 (respectivement de la couche conductrice 220) située dans la zone 100b (respectivement dans la zone 100a)

Dans un profil en arc de cercle, la section des plots 240 varie de façon continue, par exemple en augmentant progressivement de la base au sommet des piliers (soit la face supérieure des motifs 210'-220'). Dans un profil à encoche, la section de chaque plot 240 est d'abord constante dans une partie inférieure du plot, puis augmente brusquement dans sa partie supérieure, à proximité du sommet. Cette variation de section peut être continue ou bien discontinue.

Tous les matériaux susmentionnés peuvent être gravés par un plasma réactif à base de fluor (sauf aluminium) ou de chlore (y compris l'aluminium), voire de brome. Le besoin de réaliser des flancs en retrait requiert une chimie de gravure qui puisse donner lieu à des réactions spontanées entre le matériau et le gaz de gravure. On choisira donc préférentiellement les gaz contenant du chlore, tel que HCl, Cl₂ et BCl₃, ou du fluor comme SF₆, NF₃, CF₄. Il est également possible d'utiliser des mélanges de gaz à base de chlore et de fluor, ou des mélanges de gaz à base de chlore et de brome (par exemple, HBr est une source de brome)

Pour créer un profil en arc de cercle ou en « tonneau », tout en évitant la sur-gravure sous les motifs 231 du masque 230, les conditions de gravure réactive pourront être choisies comme suit :
- la puissance du champ électromagnétique radiofréquence qui génère le plasma est avantageusement comprise entre 150 W et 500 W, afin de limiter la formation de radicaux à base de chlore ;
- la tension de polarisation appliquée au porte-substrat est, de préférence, comprise entre 15 V et 1 kV, et avantageusement inférieure à 200 V.

Ces paramètres peuvent être ajustés, notamment en cours de gravure, pour contrôler la courbure de l'arc. Par exemple, une augmentation de la puissance RF permet d'augmenter la concentration de radicaux et donc d'augmenter la courbure. Une augmentation de la puissance de polarisation tend à réduire la composante chimique de la gravure et donc à réduire l'amplitude du tonneau. L'ajout d'un gaz diluant (Ar, Xe, He, N₂...), pour diminuer la concentration de chlore dans la phase gazeuse, ou l'ajout d'un gaz passivant, tend à rendre le plasma moins réactif et donc à réduire les réactions de gravure spontanées qui créent la courbure des flancs. Pour créer un profil à encoche, un procédé de gravure en deux ou trois étapes peut être utilisé. Pendant la première étape, on grave les couches 210, 220 et la portion supérieure de la couche 200 (typiquement sur 50 % de son épaisseur) de façon anisotrope pour obtenir des flancs verticaux. Ces flancs verticaux sont obtenus grâce à la formation progressive d'une couche de passivation sur les parois des motifs gravés (210', 220 ' et une partie de 200'), cette couche de passivation empêchant ensuite la gravure latérale. Pendant la dernière étape, une gravure isotrope est effectuée pour graver la portion restante de la couche 200, verticalement en direction du substrat 100 mais également latéralement. La partie supérieure de la couche 200 est protégée par la couche de passivation formée précédemment lors de la première étape de gravure. Avantageusement, une étape d'oxydation intermédiaire est réalisée pour renforcer la couche de passivation.

A titre d'exemple, des piliers à encoche en polysilicium dopé peuvent être obtenus grâce à une gravure par plasma à couplage inductif à base de HBr/Cl₂/O₂ (110 sccm/70 sccm/2 sccm) avec une énergie des ions comprise entre de 70 eV et 80 eV, suivie d'une gravure par un plasma à base de Cl₂ et SF₆ (60 sccm/3 sccm) avec une énergie des ions du même ordre de grandeur. Dans le cas d'une couche conductrice 200 en TiN, on peut effectuer la première étape de gravure avec un plasma à couplage inductif à base de HBr/Cl₂ (100 sccm/50 sccm), suivie d'une étape intermédiaire de gravure par plasma inductif à base d'O₂ pour oxyder les flancs, et enfin une gravure par plasma inductif à base de Cl₂ (éventuellement précédée d'un plasma identique avec des ions fortement énergétiques (≥ 50 eV) pour retirer l'oxyde de titane du front de gravure).

Un empilement de couches en matériaux différents, comme celui des couches 200 et 210 dans la zone 100b, ou des couches 200 et 220 dans la zone 100a, facilite grandement la formation de piliers à encoche. En effet, le matériau de la couche supérieure 210 ou 220 peut être gravé de façon anisotrope, alors que le matériau de la couche inférieure 200 est gravé de façon isotrope, sans modifier le profil de la couche supérieure. Les motifs 210' et 220' provenant respectivement des couches 210 et 220 présentent alors des flancs droits tandis que les motifs 200' provenant de la couche 200 présentent des flancs surplombants (cf. Fig.2C).

Par exemple, le titane d'un empilement Ti/Si et le ruthénium d'un empilement Ru/Si peuvent être gravés simultanément par un plasma inductif à base d'oxygène et de dichlore ou de chlorure d'hydrogène (HCl). Un gaz de dilution comme Ar, H₂, N₂ ou He peut éventuellement être ajouté dans la phase gazeuse du plasma. La couche de silicium peut alors être gravée à l'aide d'un plasma inductif à base de SF₆ ou de NF₃, éventuellement dilué par de l'argon ou de l'hélium.

Après avoir obtenu des piliers 240 à la forme souhaitée, le masque de gravure 230 est éliminé, préférentiellement par voie humide (par exemple dans une solution d'acide fluorhydrique).

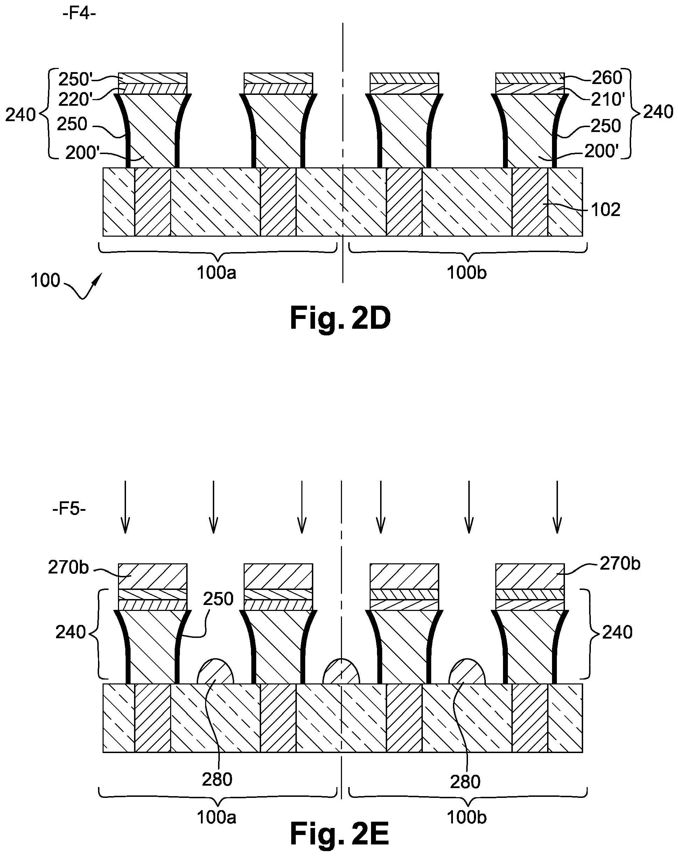

La figure 2D représente une étape F4 dans laquelle les plots 240 des zones 100a et 100b sont oxydés simultanément. Cela peut être obtenu en soumettant le substrat 100 à un traitement thermique (par exemple entre 20 °C et 450 °C) sous une atmosphère oxydante ou à un plasma à base d'oxygène. Cette étape F4 permet de former une couche isolante sur toutes les surfaces des plots 240 exposées au traitement d'oxydation, en particulier sur les flancs des plots conducteurs 240, ce qui renforce leur isolation. Par exemple, une couche isolante 250 en oxyde de tantale (Ta₂O₅) recouvre les flancs des motifs conducteurs 200' en tantale. En outre, dans le mode de mise oeuvre particulier de la figure 2D, les motifs en ruthénium 210' et les motifs en titane 220' sont également oxydées lors de l'étape F4.

D'une part, une couche isolante 250' en oxyde de titane (TiO₂) se forme en face supérieure des plots 240 situés dans la zone 100a. Cette couche d'oxyde 250' rend non linéaire la caractéristique courant-tension de chaque point mémoire OxRAM. De préférence, les conditions du traitement d'oxydation sont choisies de telle sorte qu'une partie seulement des motifs conducteurs 220' soit oxydée pour former la couche isolante 250', en l'occurrence leur partie supérieure. Par exemple, le traitement d'oxydation peut être un recuit réalisé sous une atmosphère contenant du dioxygène (O₂), à une température comprise entre 350 °C et 400 °C pendant une durée comprise entre 350 s et 1500 s. Ainsi, la portion de motifs 220' laissée intacte par le traitement d'oxydation, i.e. leur partie inférieure, peut jouer le rôle d'électrode inférieure dans le point mémoire OxRAM. Lorsque les motifs 220' de titane sont entièrement oxydés, l'électrode inférieure des points mémoire OxRAM peut être constituée par les plots conducteurs 240.

D'autre part, une couche 260 en oxyde de ruthénium (RuO) se forme en face supérieure des plots 240 de la zone 100b. Comme l'oxyde de ruthénium est conducteur d'électricité, un courant électrique peut circuler sans discontinuité de la base des plots 240 (en contact avec les via conducteurs 102 du substrat 100) jusqu'aux sommets des plots sur lesquels vont être déposés les éléments mémoire de type MRAM ou PCRAM. A l'inverse, dans la zone 100a destinée aux points mémoire OxRAM, la continuité électrique n'est pas nécessaire. L'électrode inférieure d'un point mémoire OxRAM sans sélecteur peut faire transiter l'oxyde bistable d'un état à l'autre (on parle de « claquage » de l'oxyde bistable) à travers la couche isolante 250'.

Ainsi, la couche de protection 210 protège la face supérieure des plots conducteurs 240 de la zone 100b dans le sens où cette face supérieure reste conductrice électriquement après le traitement d'oxydation. Plutôt qu'une couche en ruthénium dont l'oxyde est conducteur, on peut utiliser une couche de protection en un matériau conducteur et insensible au traitement d'oxydation, par exemple en métal noble (Au, Ag, Pt...).

A l'étape F5 représentée par la figure 2E, des éléments mémoire 270b de type MRAM ou PCRAM sont formés par dépôt physique en phase vapeur (« Physical Vapor Deposition », PVD) aux sommets des piliers 240 de la zone 100b. De préférence, ces mêmes éléments 270b sont formés simultanément aux sommets des piliers 240 de la zone 100a, comme illustré sur la figure 2E. Chaque élément mémoire 270b est ainsi supporté par un pilier 240 de la zone 100a ou de la zone 100b.

La pulvérisation cathodique est avantageusement utilisée à l'étape de dépôt F5. Cette technique présente une certaine directivité permettant de diriger le dépôt de matériau résistif conducteur des éléments mémoire 270b vers les piliers 240, notamment à leur sommet. Toutefois, du matériau résistif se dépose également au fond des tranchées situées entre les piliers 240, voire sur une partie des flancs des piliers suivant l'incidence du dépôt et la dispersion angulaire du flux d'atomes issus de la cible pulvérisée, formant alors des dépôts résiduels 280. En incidence normale par rapport à la surface du substrat (cas représenté sur la figure 2E), ces dépôts résiduels 280 sont localisés autour du centre des tranchées. Plus les flancs des piliers 240 sont surplombants, moins les dépôts 280 s'étalent à proximité de la base des flancs. En incidence oblique (cas non représenté), les dépôts 280 peuvent être situés d'un seul et même côté des piliers 240.

La formation de flancs en retrait empêche donc le dépôt simultané de matériau résistif sur deux flancs se faisant face et appartenant à des piliers différents, ce qui évite un court-circuit entre ces deux piliers (même en l'absence de la couche isolante 250 sur les flancs). De préférence, la pulvérisation cathodique est collimatée afin d'augmenter la directivité du dépôt et donc diminuer l'étendue des dépôts résiduels 280 au fond des tranchées. Les dépôts résiduels 280 peuvent être laissés tels quels. Grace à la discontinuité électrique sur les flancs des piliers 240, ils ne perturbent pas de façon significative le fonctionnement du dispositif hybride. En particulier, ils ne créent pas de courts-circuits inter-plots.

La formation des éléments 270b aux sommets des piliers 240 peut comprendre le dépôt d'un ou plusieurs matériaux résistifs, suivant la technologie de mémoire envisagée. Par exemple, pour fabriquer une jonction tunnel magnétique de mémoire MRAM, on dépose successivement une couche de référence (ex. un alliage à base de Co, Fe et B), une couche de barrière tunnel (ex. MgO) et une couche de stockage (ex. un alliage à base de Co, Fe et B, avec des concentrations identiques ou différentes de celles de la couche de référence). La couche de référence et la couche de stockage sont (ferro-)magnétiques, tandis que la couche de barrière tunnel est non-magnétique. La couche de stockage peut être située au-dessus ou en-dessous de la barrière tunnel, la couche de référence étant située de l'autre côté de la barrière tunnel par rapport à la couche de stockage. Pour une mémoire PCRAM, la couche de stockage est formée d'un matériau à changement de phase, par exemple un alliage entre les éléments germanium, antimoine et tellure. Ces matériaux sont conducteurs d'électricité. Les différentes couches des éléments 270b peuvent être déposées par des techniques différentes et suivant des incidences différentes.

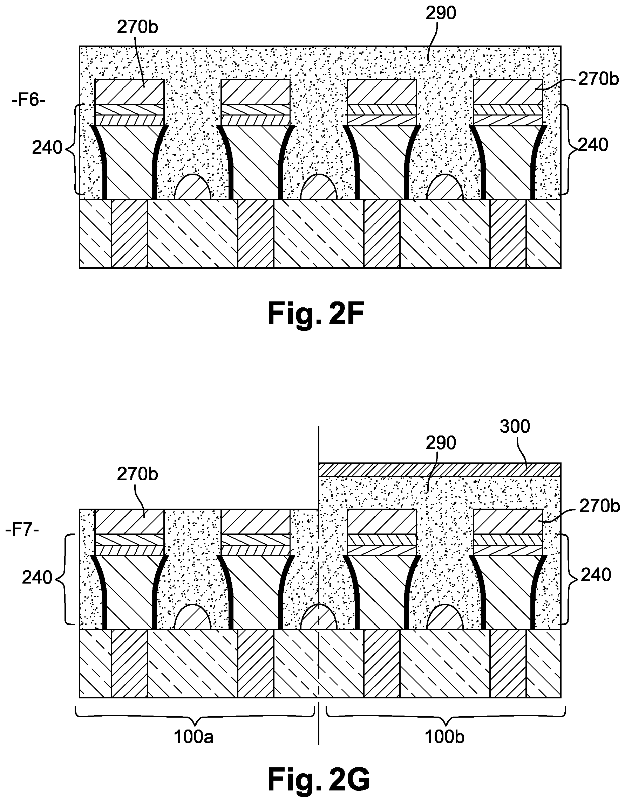

L'étape F6 de la figure 2F consiste à remplir d'un matériau diélectrique 290 l'espace entre les piliers 240, jusqu'à recouvrir entièrement leur élément de stockage 270b.

Diverses techniques de l'industrie microélectronique permettent de recouvrir de matériau diélectrique (généralement un oxyde) des structures à facteur de forme élevé (type STI, FinFET, transistor à grille « damascène »...) et/ou avec des flancs surplombants. On peut citer notamment le dépôt en phase gazeuse de films diélectriques liquides. Les diélectriques liquides sont semblables à un gel ayant les caractéristiques d'écoulement d'un liquide. En exploitant cette technique, on peut aisément remplir des structures avec des facteurs de forme supérieurs à 10, allant même jusqu'à 30. Le matériau diélectrique liquide peut être choisi parmi Si₃N₄, SiO₂, SiOₓC_{y}H_{z}, SiOₓH_{y} et SiOₓN_{y}H_{z}. Ces matériaux sont choisis pour leur résistivité électrique (avantageusement ρ > 0.1 Ω.cm) afin que les courants de fuite entre points mémoire soient minimisés. L'avantage de cette technique par rapport aux autres techniques de dépôt en phase gazeuse est l'absence de vides ou cavités dans la couche de matériau diélectrique 290.

Une alternative aux procédés en phase gazeuse est le dépôt par centrifugation. Dans ce cas, un précurseur sol-gel est dilué dans un solvant et déposé sous forme liquide sur le substrat en rotation. Sous l'effet de la force centrifuge, le liquide se répartit de façon uniforme à la surface du substrat. Les précurseurs polymérisent et le solvant s'évapore pour former un matériau diélectrique appelé « Spin On Glass » (SOG). L'épaisseur de la couche déposée est contrôlée par la viscosité du matériau et la vitesse de rotation du substrat. Les matériaux ainsi réalisés peuvent être des silices ou des silicones de type poly-méthylsiloxane, poly-métylsilsesquioxane, poly-oxycarbosilane, poly-dimétylsiloxane. Ils peuvent aussi être des polymères, tels que des résines planarisantes, par exemple celle commercialisée par la société « Honeywell » sous la dénomination « ACCUFLO ».

A l'étape F7 de la figure 2G, une portion de la couche en matériau diélectrique 290 est gravée jusqu'à ce que les éléments mémoire 270b situés dans la zone 100a soient découverts. Cette gravure est, de préférence, réalisée au moyen d'un plasma réactif. Un masque dur 300 est préalablement formé sur le matériau diélectrique 290 dans la zone 100b, pour le protéger de la gravure.

Puis, en F8, les éléments mémoire 270b de la zone 100a sont éliminés, de préférence par gravure plasma réactive. Avantageusement, le plasma grave simultanément le matériau diélectrique 290 dans la zone 100a et la gravure prend fin lorsque la couche isolante 250' est atteinte. Dans ce cas, comme le plasma n'est pas sélectif par rapport au matériau diélectrique 290, le masque 300 de l'étape précédente F7 peut à nouveau être utilisé pour protéger la zone 100b, puis celui-ci est également retiré après la gravure.

A l'étape F9 (Fig.2I), une couche d'oxyde 270, de préférence un oxyde de métal de transition choisi parmi les oxydes de hafnium (HfOₓ) et les oxydes de tantale (TaOₓ), est déposée aux sommets des plots 240 de la zone 100a. Chaque plot 240 supporte une portion de cette couche 270, qui forme un élément mémoire 270a de type OxRAM, et plus particulièrement de type OxRAM sans sélecteur en présence de la couche isolante 250'. La couche d'oxyde 270 peut être également déposée sur le matériau diélectrique 290 situé entre les plots 240 de la zone 100a et ainsi relier les différents plots 240. Néanmoins, comme elle est isolante électriquement, la couche d'oxyde 270 ne provoque pas de court-circuit entre les différents points mémoire de la matrice OxRAM. La surface du substrat est préférentiellement plane dans la zone 100a, grâce au fait que la gravure plasma de l'étape F8 est anisotrope.

Comme illustré sur la figure 2I, la couche d'oxyde 270 recouvre également la portion de couche de matériau diélectrique 290 située dans la zone 100b et dans laquelle les éléments mémoire 270b (MRAM ou PCRAM) sont enterrés. Ainsi, la couche d'oxyde 270 ne perturbe pas le fonctionnement des éléments mémoire 270b. De préférence, la couche d'oxyde 270 est déposée sur toute la surface du substrat par une technique de dépôt conforme, telle que le dépôt chimique en phase vapeur assisté par plasma (« Plasma-Enhanced Chemical Vapor Deposition, PECVD) ou le dépôt de couches atomiques (« Atomic Layer Deposition », ALD).

Le fait de déposer, à l'étape de F5 de la figure 2E, les éléments MRAM (ou PCRAM) sur les deux zones 100a et 100b du substrat simplifie grandement l'étape de PVD. De plus, le procédé jusqu'à la figure 2F peut être ainsi identique à celui permettant de former un dispositif mémoire MRAM (ou PCRAM) unique.

Une alternative aux étapes de formation des éléments mémoire 270a et 270b (Figs.2E-2I) consiste à protéger d'un matériau diélectrique la zone 100a des OxRAM avant le dépôt PVD des éléments mémoire 270b de type MRAM ou PCRAM, pour qu'ils ne soient formés que dans la zone 100b. Puis, ces éléments 270b sont recouverts de matériau diélectrique, alors que la couche de matériau diélectrique dans la zone 100a est retirée pour libérer la face supérieure des plots 240 situés dans cette zone. La couche d'oxyde 270 peut alors déposée dans la zone 100a, et (éventuellement) sur le matériau diélectrique de la zone 100b.

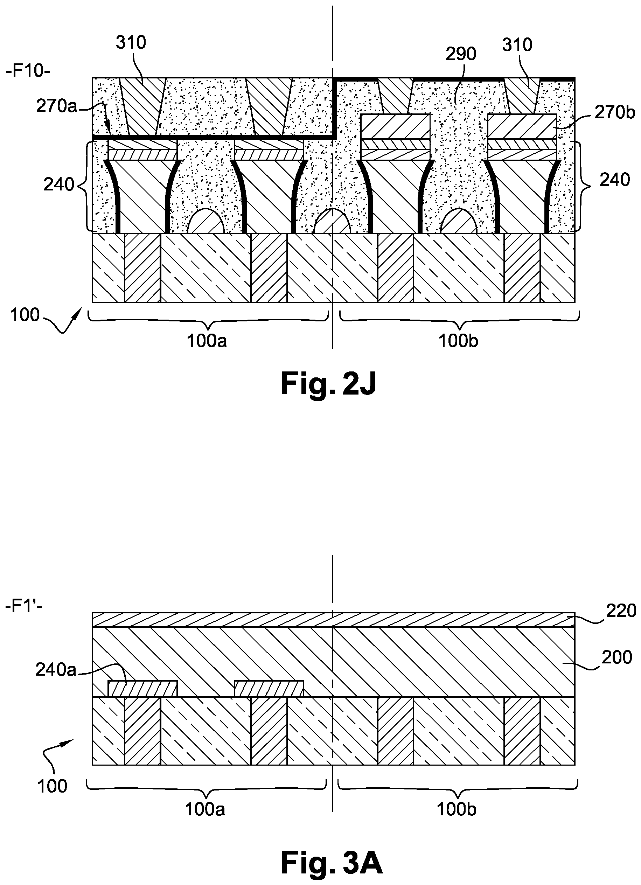

La figure 2J montre la dernière étape du procédé de fabrication, dans laquelle on forme des contacts électriques 310 aux sommets des éléments mémoire 270a et 270b. Les contacts 310 sont, de préférence, obtenus par un procédé de type « damascène ». Ce procédé « damascène » comprend classiquement le dépôt de matériau diélectrique (ici limité à la première zone 100a pour obtenir une surface plane sur tout le substrat), la gravure de cavités dans le matériau diélectrique jusqu'à atteindre les éléments mémoire 270a et 270b, puis le remplissage des cavités par un matériau conducteur, généralement un métal (Al, Cu, TiN/Ti...).

Grâce à ce procédé de fabrication, il est désormais possible de fabriquer un dispositif mémoire hybride compact et performant, comportant une pluralité de points mémoire OxRAM (sans sélecteur) dans la zone 100a du substrat 100 et une pluralité de points mémoire MRAM ou PCRAM dans la zone 100b adjacente. Chaque point mémoire est formé d'une nanostructure verticale ayant comme base un plot conducteur 240. Les points mémoire OxRAM dispose d'une couche de stockage isolante 270a, tandis que les points mémoire MRAM ou PCRAM comprennent chacun un élément mémoire 270b muni d'au moins une couche de stockage conductrice.

Ce procédé est particulièrement simple à mettre en oeuvre, car plusieurs étapes sont communes aux première et seconde zones 100a-100b du substrat, notamment les étapes de formation des plots conducteurs 240 (dans le mode de mise en oeuvre des figures 2A à 2J) et l'étape F4 d'oxydation des plots conducteurs. En effet, cette dernière étape forme simultanément la couche de rectification dans la zone 100a et des flancs isolants dans la zone 100b (et éventuellement dans la zone 100a, bien que de tels flancs y soient inutiles).

De nombreuses variantes et modifications du procédé de fabrication de dispositif mémoire hybride apparaitront à l'homme du métier. En particulier, l'ordre dans lequel sont formés les deux types d'éléments mémoire est susceptible de varier. En outre, le procédé de fabrication, décrit jusqu'ici en relation avec les figures 2A à 2J, peut ne pas employer la seconde couche conductrice 220 et/ou la couche de protection 210 en ruthénium ou métal noble.

Pour protéger la face supérieure des plots 240 dans la zone MRAM/PCRAM 100b, on peut notamment se servir du masque de gravure 230 (utilisé à l'étape F3 de gravure des plots 240 ; Fig.2C) lors de l'étape d'oxydation F4 et ne le retirer qu'après. Le masque de gravure 230 (ou plus exactement ses motifs 231 situés dans la zone 100b) constitue alors la couche de protection. On peut autrement déposer aux sommets des plots 240 de la zone 100b un autre matériau protecteur dit sacrificiel, tel qu'un nitrure de silicium (SiN, Si₃N₄, SiOCN, SiNH) ou un oxyde de silicium (SiO₂). Le matériau protecteur est retiré après l'étape d'oxydation F4, pour rendre à nouveau conductrice la face supérieure des piliers 240. Dans ces deux cas, les plots conducteurs 240 de la zone 100b sont uniquement constitués du matériau de la couche conductrice 200.

De même, si l'on s'affranchit de la seconde couche conductrice 220, les plots conducteurs 240 de la zone 100b sont uniquement constitués des motifs 200' issus de la première couche conductrice 200. C'est donc la portion supérieure de ces motifs 200' qui sera oxydée lors de l'étape F4 et qui jouera le rôle de couche de rectification dans les OxRAM, tandis que la portion inférieure des motifs 200' agira comme une électrode.

Enfin, les figures 3A à 3C représentent une variante de mise en oeuvre du procédé de fabrication dans laquelle les plots conducteurs de la zone OxRAM 100a sont formés avant les plots conducteurs de la zone MRAM ou PCRAM 100b.

A l'étape F1' (Fig.3A), des plots conducteurs 240a sont formés dans la première zone 100a du substrat 100, par exemple par photolithographie puis gravure. Ces plots 240a sont, de préférence, formés du matériau de la seconde couche conductrice 220 décrite ci-dessus, c'est-à-dire un matériau présentant des propriétés de rectification une fois oxydé, par exemple en titane. La première couche conductrice 200 est ensuite déposée sur la zone 100b, et de préférence sur toute la surface du substrat 100, puis avantageusement recouverte par la couche de protection 220.

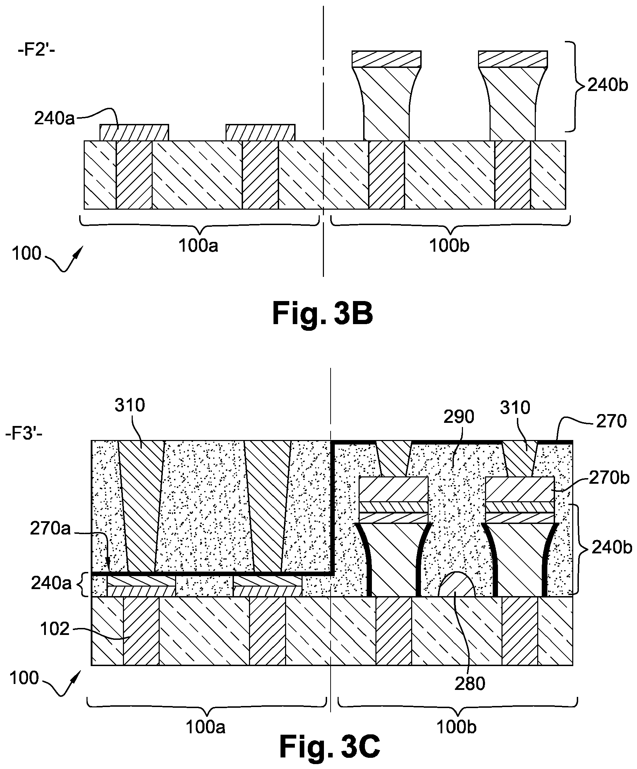

En F2' (Fig.3B), la couche conductrice 200 et la couche de protection 220 sont gravées pour former les piliers conducteurs 240b dans la zone 100b et entièrement retirées dans la zone 100a, de façon à libérer les plots conducteurs 240a situés à la surface du substrat 100. Les plots 240a peuvent être de forme ramassée comparés aux piliers 240b et posséder des flancs verticaux. Cela n'est pas problématique puisqu'il est inutile de discrétiser la couche active (270) des points mémoire OxRAM.

Ainsi, dans cette variante de mise en oeuvre, les plots conducteurs 240a de la zone 100a peuvent être de forme et de nature différentes des plots conducteurs 240b de la zone 100b. En outre, ils constituent l'électrode inférieure des points mémoire OxRAM.

Le reste du procédé de fabrication, représenté par l'étape F3' de la figure 3C, s'effectue comme décrit ci-dessus en relation avec les figures 2D à 2J (étapes F4 à F10). On notera que, à cause de leur hauteur plus faible, les plots 240a de la zone 100a nécessitent des contacts électriques 310 plus profonds que ceux des piliers 240b située dans la zone 100b adjacente, et que les dépôts résiduels 280 de matériau résistif MRAM ou PCRAM peuvent être facilement éliminés dans la zone OxRAM 100a (en retirant entièrement le matériau diélectrique 290 dans la zone 100a, à l'étape F7 de la figure 2G).

En dehors des éléments évoqués ci-dessus, le dispositif mémoire hybride illustré sur la figure 3C est identique à celui de la figure 2J. Les éléments repris portent les mêmes signes de référence.

## Revendications

1. Procédé de fabrication d'un dispositif mémoire non-volatile hybride comprenant les étapes suivantes :
- former (F1-F3 ; F1') un premier groupe de plots électriquement conducteurs (240 ; 240a) espacés les uns des autres dans une première zone (100a) d'un substrat (100) ;
- déposer (F1) une première couche électriquement conductrice (200) sur une seconde zone (100b) du substrat (100) ;
- graver (F3) la première couche conductrice (200), de sorte à obtenir un second groupe de plots électriquement conducteurs (240 ; 240b) espacés les uns des autres dans la seconde zone (100b), les conditions de gravure étant choisies de sorte que les plots conducteurs de la seconde zone aient une section à leur base plus petite qu'à leur sommet ;
- protéger la face supérieure des plots conducteurs (240 ; 240b) de la seconde zone (100b) ;
- soumettre (F4) le substrat à un traitement d'oxydation, d'où il résulte une couche en matériau isolant (250, 250') recouvrant la face supérieure des plots conducteurs (240 ; 240a) de la première zone (100a) et les flancs des plots conducteurs (240 ; 240b) de la seconde zone (100b) ;
- déposer (F9) une couche d'oxyde (270) aux sommets des plots conducteurs (240 ; 240a) de la première zone (100a), d'où il résulte des éléments mémoire (270a) d'un premier type supportés par les plots conducteurs de la première zone ; et
- former (F5) par dépôt physique en phase vapeur des éléments mémoire (270b) d'un second type aux sommets des plots conducteurs (240 ; 240b) de la seconde zone (100b), de sorte que chaque élément mémoire du second type est supporté par l'un des plots conducteurs de la seconde zone.

2. Procédé selon la revendication 1, dans lequel les plots conducteurs (240) de la première zone (100a) sont formés en même temps que les plots conducteurs (240) de la seconde zone (100b), en gravant la première couche conductrice (200) préalablement déposée sur les première et seconde zones (100a, 100b).

3. Procédé selon la revendication 2, comprenant le dépôt d'une seconde couche conductrice (220) sur la première couche conductrice (200) dans la première zone (100a), les première et seconde couches conductrices étant gravées simultanément pour former les plots conducteurs (240) de la première zone.

4. Procédé selon la revendication 3, dans lequel la seconde couche conductrice (220) est en titane.

5. Procédé selon la revendication 1, dans lequel les plots conducteurs (240a) de la première zone (100a) sont formés avant le dépôt de la première couche conductrice (200) sur la seconde zone.

6. Procédé selon l'une quelconque des revendications 1 à 5, dans lequel les éléments mémoire (270b) du second type sont formés simultanément par dépôt physique en phase vapeur aux sommets des plots conducteurs (240 ; 240a) de la première zone (100a) et aux sommets des plots conducteurs (240 ; 240b) de la seconde zone (100b), le procédé comprenant en outre, avant l'étape (F9) de dépôt de la couche d'oxyde, les étapes suivantes :
- recouvrir (F6) d'un matériau diélectrique (290) les plots conducteurs (240 ; 240a, 240b) des première et seconde zones (100a, 100b) ;
- graver le matériau diélectrique (290) dans la première zone (100a) jusqu'à découvrir les éléments mémoire (270b) du second type situés dans la première zone ; et
- éliminer les éléments mémoire (270b) du second type dans la première zone (100a).

7. Procédé selon la revendication 6, dans lequel la couche d'oxyde (270) est déposée sur les première et seconde zones (100a, 100b) par PECVD ou ALD.

8. Procédé selon l'une quelconque des revendications 1 à 7, dans lequel la face supérieure des plots conducteurs (240 ; 240b) de la seconde zone (100b) est protégée en formant dans la seconde zone une couche de protection (210) sur la première couche conductrice (200), avant l'étape (F3) de gravure de la première couche conductrice (200).

9. Procédé selon la revendication 8, dans lequel la couche de protection (210) occupe toute la seconde zone (100b) et est gravée en même temps que la première couche conductrice (200) pour former les plots conducteurs (240 ; 240b) de la seconde zone (100b).

10. Procédé selon la revendication 9, dans lequel la couche de protection (210) est en ruthénium.

11. Procédé selon la revendication 8, dans lequel la couche de protection est constituée par un masque de gravure (230) servant à graver la première couche conductrice (200).

12. Procédé selon la revendication 11, dans lequel la couche de protection (230) est retirée après le traitement d'oxydation (F4).

13. Procédé selon l'une des quelconque des revendications 1 à 12, dans lequel la première couche conductrice (200) est gravée par gravure plasma réactive.

14. Dispositif mémoire non-volatile hybride comprenant :
- un substrat (100) comportant des première et seconde zones (100a, 100b) ;
- une pluralité de plots électriquement conducteurs (240 ; 240a, 240b) disposés sur le substrat (100) et répartis entre les première et seconde zones (100a, 100b), les plots de la seconde zone (100b) ayant une section à leur base plus faible qu'à leur sommet ;
- une couche électriquement isolante (250, 250') recouvrant les flancs des plots conducteurs (240 ; 240b) de la seconde zone (100b) et au moins la face supérieure des plots conducteurs (240 ; 240a) de la première zone (100a); **caractérisé par**
- une première couche de stockage (270) en oxyde recouvrant les plots conducteurs (240 ; 240a) de la première zone (100a), d'où il résulte une pluralité d'éléments mémoire (270a) d'un premier type dans la première zone (100a) ; et par
- une pluralité d'éléments mémoire (270b) d'un second type disposés aux sommets des plots conducteurs (240 ; 240b) de la seconde zone (100b), de sorte que chaque élément mémoire est supporté par l'un des plots conducteurs de la seconde zone, les éléments mémoire (270b) du second type comprenant une seconde couche de stockage électriquement conductrice.

15. Dispositif selon la revendication 14, dans lequel les éléments mémoire (270a) du premier type sont des éléments de mémoire OxRAM sans sélecteur et dans lequel les éléments mémoire (270b) du second type sont des éléments de mémoire PCRAM ou MRAM.

## Patentansprüche

1. Herstellungsverfahren einer hybriden, nicht flüchtigen Speichervorrichtung, umfassend die folgenden Schritte:
- Bilden (F1-F3; F1') einer ersten Gruppe von elektrisch leitenden Klötzchen (240; 240a), die voneinander in einem ersten Bereich (100a) eines Substrats (100) beabstandet sind;
- Aufbringen (F1) einer ersten elektrisch leitenden Schicht (200) auf einem zweiten Bereich (100b) des Substrats (100);
- Ätzen (F3) der ersten leitenden Schicht (200) derart, dass eine zweite Gruppe von elektrisch leitenden Klötzchen (240; 240b) erhalten wird, die voneinander in dem zweiten Bereich (100b) beabstandet sind, wobei die Ätzbedingungen derart ausgewählt sind, dass die leitenden Klötzchen einen Abschnitt haben, der an ihrer Basis kleiner ist als an ihrer Spitze;
- Schutz der oberen Seite der leitenden Klötzchen (240; 240b) des zweiten Bereichs (100b);
- Unterziehen (F4) des Substrats einer Oxidationsbehandlung, aus der eine Schicht aus Isolationsmaterial (250; 250') resultiert, die die obere Seite der leitenden Klötzchen (240; 240a) des ersten Bereichs (100a) und die Flanken der leitenden Klötzchen (240; 240b) des zweiten Bereichs (100b) abdeckt;
- Aufbringen (F9) einer Oxidschicht (270) an den Spitzen der leitenden Klötzchen (240; 240a) des ersten Bereichs (100a), aus der Speicherelemente (270a) eines ersten Typs resultieren, die von den leitenden Klötzchen des ersten Bereichs getragen werden; und
- Bilden (F5) per physischer Aufbringung in der Dampfphase der Speicherelemente (270b) eines zweiten Typs an den Spitzen der leitenden Klötzchen (240; 240b) des zweiten Bereichs (100b) derart, dass jedes Speicherelement des zweiten Typs von einem der leitenden Klötzchen des zweiten Bereichs getragen wird.

2. Verfahren gemäß Anspruch 1, bei dem die leitenden Klötzchen (240) des ersten Bereichs (100a) gleichzeitig mit den leitenden Klötzchen (240) des zweiten Bereichs (100b) durch Ätzen der ersten leitenden Schicht (200) gebildet sind, bevor sie auf den ersten und zweiten Bereich (100a, 100b) aufgebracht werden.

3. Verfahren gemäß Anspruch 2, umfassend das Aufbringen einer zweiten leitenden Schicht (220) auf der ersten leitenden Schicht (200) in dem ersten Bereich (100a), wobei die erste und zweite leitende Schicht gleichzeitig geätzt werden, um die leitenden Klötzchen (240) der ersten Schicht zu bilden.

4. Verfahren gemäß Anspruch 3, bei dem die zweite leitende Schicht (220) aus Titan ist.

5. Verfahren gemäß Anspruch 1, bei dem die leitenden Klötzchen (240a) der ersten Schicht (100a) vor dem Aufbringen der ersten leitenden Schicht (200) auf den zweiten Bereich gebildet werden.

6. Verfahren gemäß irgendeinem der Ansprüche 1 bis 5, bei dem die Speicherelemente (270b) des zweiten Typs gleichzeitig per physischem Aufbringen in der Dampfphase an den Spitzen der leitenden Klötzchen (240; 240a) des ersten Bereichs (100a) und an den Spitzen der leitenden Klötzchen (240; 240b) des zweiten Bereichs (100b) gebildet werden, wobei das Verfahren darüber hinaus vor dem Schritt (F9) des Aufbringens der Oxidschicht die folgenden Schritte umfasst:
- Abdecken (F6) der leitenden Klötzchen (240; 240a, 240b) des ersten und zweiten Bereichs (100a, 100b) mit einem dielektrischen Material (290);
- Ätzen des dielektrischen Materials (290) in dem ersten Bereich (100a) bis zum Freilegen der Speicherelemente (270b) des zweiten Typs, die sich in dem ersten Bereich befinden; und
- Entfernen der Speicherelemente (270b) des zweiten Typs in dem ersten Bereich (100a).

7. Verfahren gemäß Anspruch 6, bei dem die Oxidschicht (270) auf dem ersten und zweiten Bereich (100a, 100b) per PECVD oder ALD aufgebracht ist.

8. Verfahren gemäß irgendeinem der Ansprüche 1 bis 7, bei dem die obere Seite der leitenden Klötzchen (240; 240b) des zweiten Bereichs (100b) durch Bilden einer Schutzschicht (210) in dem zweiten Bereich auf der ersten leitenden Schicht (200) vor dem Ätzschritt (F3) der ersten leitenden Schicht (200) geschützt ist.

9. Verfahren gemäß Anspruch 8, bei dem die Schutzschicht (210) den gesamten zweiten Bereich (100b) einnimmt und gleichzeitig mit der ersten leitenden Schicht (200) geätzt wird, um die leitenden Klötzchen (240; 240b) des zweiten Bereichs (100b) zu bilden.

10. Verfahren gemäß Anspruch 9, bei dem die Schutzschicht (210) aus Ruthenium ist.

11. Verfahren gemäß Anspruch 8, bei dem die Schutzschicht durch eine Ätzmaske (230) gebildet ist, die zum Ätzen der ersten leitenden Schicht (200) dient.

12. Verfahren gemäß Anspruch 11, bei dem die Schutzschicht (230) nach der Oxidationsbehandlung (F4) abgenommen wird.

13. Verfahren gemäß irgendeinem der Ansprüche 1 bis 12, bei dem die erste leitende Schicht (200) per reaktiver Plasmagravur geätzt wird.

14. Hybride, nicht flüchtige Speichervorrichtung, umfassend:
- ein Substrat (100), umfassend erste und zweite Bereiche (100a, 100b);
- eine Vielzahl von elektrisch leitenden Klötzchen (240; 240a, 240b), die auf dem Substrat (100) angeordnet und zwischen dem ersten und zweiten Bereich (100a, 100b) verteilt sind, wobei die Klötzchen des zweiten Bereichs (100b) einen Abschnitt haben, der an ihrer Basis kleiner ist als an ihrer Spitze;
- eine elektrisch leitende Isolationsschicht (250, 250'), die die Flanken der leitenden Klötzchen (240; 240b) des zweiten Bereichs (100b) und wenigstens die obere Seite der leitenden Klötzchen (240; 240a) des ersten Bereichs (100a) abdeckt;
**gekennzeichnet durch**:
- eine erste Lagerschicht (270) aus Oxid, die die leitenden Klötzchen (240; 240a) des ersten Bereichs (100a) abdeckt, woraus eine Vielzahl von Speicherelementen (270a) eines ersten Typs in dem ersten Bereich (100a) resultiert; und durch
- eine Vielzahl von Speicherelementen (270b) eines zweiten Typs, die an den Spitzen der leitenden Klötzchen (240; 240b) des zweiten Bereichs (100b) derart angeordnet sind, dass jedes Speicherelement von einem der leitenden Klötzchen des zweiten Bereichs getragen wird, wobei die Speicherelemente (270b) des zweiten Typs eine zweite elektrisch leitende Lagerschicht umfassen.

15. Vorrichtung gemäß Anspruch 14, bei der die Speicherelemente (270a) des ersten Typs Speicherelemente OxRAM ohne Auswahlvorrichtung sind und bei dem die Speicherelemente (270b) des zweiten Typs Speicherelemente PCRAM oder MRAM sind.

## Claims

1. Method for manufacturing a hybrid non-volatile memory device comprising the following steps:
- forming (F1-F3; F1') a first group of electrically conductive pads (240; 240a) spaced apart from each other in a first area (100a) of a substrate (100);
- depositing (F1) a first electrically conductive layer (200) on a second area (100b) of the substrate (100);
- etching (F3) the first conductive layer (200), so as to obtain a second group of electrically conductive pads (240; 240b) spaced apart from each other in the second area (100b), the etching conditions being chosen such that the conductive pads of the second area have a section at their base smaller than at their top;
- protecting the upper face of the conductive pads (240; 240b) of the second area (100b);
- subjecting (F4) the substrate to an oxidation treatment, resulting in a layer made of insulating material (250, 250') covering the upper face of the conductive pads (240; 240a) of the first area (100a) and the sides of the conductive pads (240; 240b) of the second area (100b);
- depositing (F9) an oxide layer (270) at the tops of the conductive pads (240; 240a) of the first area (100a), resulting in memory elements (270a) of a first type supported by the conductive pads of the first area; and
- forming (F5) by physical vapor deposition memory elements (270b) of a second type at the tops of the conductive pads (240; 240b) of the second area (100b), such that each memory element of the second type is supported by one of the conductive pads of the second area.

2. Method according to claim 1, wherein the conductive pads (240) of the first area (100a) are formed at the same time as the conductive pads (240) of the second area (100b), by etching the first conductive layer (200) deposited beforehand on the first and second areas (100a, 100b).

3. Method according to claim 2, comprising the deposition of a second conductive layer (220) on the first conductive layer (200) in the first area (100a), the first and second conductive layers being etched simultaneously to form the conductive pads (240) of the first area.

4. Method according to claim 3, wherein the second conductive layer (220) is made of titanium.

5. Method according to claim 1, wherein the conductive pads (240a) of the first area (100a) are formed before the deposition of the first conductive layer (200) on the second area.

6. Method according to any one of claims 1 to 5, wherein the memory elements (270b) of the second type are formed simultaneously by physical vapor deposition at the tops of the conductive pads (240; 240a) of the first area (100a) and at the tops of the conductive pads (240; 240b) of the second area (100b), the method further comprising, before the step (F9) of depositing the oxide layer, the following steps:
- covering (F6) with a dielectric material (290) the conductive pads (240; 240a, 240b) of the first and second areas (100a, 100b);
- etching the dielectric material (290) in the first area (100a) until the memory elements (270b) of the second type situated in the first area are revealed; and
- eliminating the memory elements (270b) of the second type in the first area (100a).

7. Method according to claim 6, wherein the oxide layer (270) is deposited on the first and second areas (100a, 100b) by PECVD or ALD.

8. Method according to any one of claims 1 to 7, wherein the upper face of the conductive pads (240; 240b) of the second area (100b) is protected by forming in the second area a protective layer (210) on the first conductive layer (200), before the step (F3) of etching the first conductive layer (200).

9. Method according to claim 8, wherein the protective layer (210) occupies all the second area (100b) and is etched at the same time as the first conductive layer (200) to form the conductive pads (240; 240b) of the second area (100b).

10. Method according to claim 9, wherein the protective layer (210) is made of ruthenium.

11. Method according to claim 8, wherein the protective layer is constituted of an etching mask (230) used to etch the first conductive layer (200).

12. Method according to claim 11, wherein the protective layer (230) is removed after the oxidation treatment (F4).

13. Method according to any of claims 1 to 12, wherein the first conductive layer (200) is etched by reactive plasma etching.

14. Hybrid non-volatile memory device comprising:
- a substrate (100) comprising first and second areas (100a, 100b);
- a plurality of electrically conductive pads (240; 240a, 240b) arranged on the substrate (100) and spread out between the first and second areas (100a, 100b), the pads of the second area (100b) having a section at their base smaller than at their top;
- an electrically insulating layer (250, 250') covering the sides of the conductive pads (240; 240b) of the second area (100b) and at least the upper face of the conductive pads (240; 240a) of the first area (100a); **characterized by**:
- a first storage layer (270) made of oxide covering the conductive pads (240; 240a) of the first area (100a), resulting in a plurality of memory elements (270a) of a first type in the first area (100a); and by
- a plurality of memory elements (270b) of a second type arranged at the tops of the conductive pads (240; 240b) of the second area (100b), such that each memory element is supported by one of the conductive pads of the second area, the memory elements (270b) of the second type comprising a second electrically conducting storage layer.

15. Device according to claim 14, wherein the memory elements (270a) of the first type are selector-less OxRAM memory elements and wherein the memory elements (270b) of the second type are PCRAM or MRAM memory elements.
